# EUROPEAN PATENT SPECIFICATION

(11) **EP 2 884 773 B1**
(45) Date of publication and mention of the grant of the patent: **15.02.2017**
(21) Application number: 13196359.7
(22) Date of filing: 10.12.2013
(51) Int. Cl.: H04R 29/00, H03F 3/187, H03F 3/68, H03F 1/52, H04B 1/74

(54) **Public address system and method**
Beschallungsanlage und Verfahren
Système d'adresse publique et procédé

(43) Date of publication of application: 17.06.2015
(73) Proprietor: Televic Rail NV, 8870 Izegem (BE)
(72) Inventor: Vercoutter, Bart, 8501 Bissegem (BE); Claeys, Luc, 8700 Tielt (BE); Van Den Oudenhoven, Jan, 9000 Gent (BE); Boerjan, Kristof, 8310 Assebroek (BE); Gesquiere, John, 8970 Poperinge (BE)
(74) Representative: Van Bladel, Marc

(56) References cited:
- EP-A1- 1 802 175
- EP-A2- 2 381 703
- WO-A1-2005/069685
- WO-A2-2008/036992

## Description

### Field of the invention

The present invention is generally related to the field of public address (PA) systems as used in public transportation means.

### Background of the invention

In a lot of public announcement systems the speaker is not aware of whether or not the announcement is broadcasted in all areas. For some applications it is highly recommended that the speaker have an indication if the announcement could not be broadcasted.

One option is to perform a regular manual intervention to verify if all loudspeaker branches in the different rooms are still functioning properly. Obviously, this solution requires a related effort, which highly depends on the accuracy and repetition rate of verification. As in practice this effort is often kept to a minimum, it leaves possibilities for dormant failures and thus unavailability of the system for message broadcasting in a certain area.

Another solution is an automated measurement of the system. However, speech is a complex waveform which is difficult to analyze if one wants to check the correctness of the signal. Due to reflections of the direct sound waveform at the room boundaries, the signal becomes even more difficult to use for testing the correct broadcasting. A way out is to make use of a simple test signal, but it may be found annoying to distribute a test signal while the rooms are occupied by people. Therefore those tests are only performed when no persons are present in the room. This scheduled testing leaves again time intervals where dormant failures can occur in the system.

As already mentioned, acoustical audio is difficult to measure due to reflections. Another disturbing factor is the noise present in the room. Examples are noise caused by air conditioning, people talking, etc. Performing an acoustical measurement is therefore in some current solutions no option and only electrical line verification is done. This is applied in state of the art techniques like end of line detection, impedance measurement and back-EMF of the loudspeakers. The loudspeakers or their acoustical characteristics are thereby only partially tested or even not tested at all, depending on the applied measurement technique. This leaves the system with still a possible dormant failure within the loudspeakers of the system. The measurement doesn't even make use of the speech signal which needs to be announced. Accordingly the measurement gives no relevant information of the announcement being correctly broadcasted or not. The measurement only indicates whether the loudspeaker lines are capable of transmitting signal to the loudspeakers.

State of the art techniques like impedance measurements of the loudspeaker branch or back-EMF require complex measurement circuitry and do not allow for verification of the broadcasted signal. Back-EMF is a technique whereby a signal pulse is sent on the loudspeaker branch and the loudspeakers return a signal pulse, which allows checking the presence of loudspeakers on the line.

Acoustical measurements have been performed with microphones in the past. Analyzing techniques depend on the time shift of signals from different loudspeakers before reaching the microphone. These solutions however imply an intrusive measurement (no verification of the broadcasted signal), so they cannot be applied for continuous testing.

Application EP2381703 relates to a method and device for monitoring a loudspeaker line of a public address system. A main module is arranged at a point of a loudspeaker line and a monitoring module is arranged at another distant point of the loudspeaker line. The two modules can communicate with each other. In order to transmit the digital communication signal the impedance changes between the loudspeaker line and a ground reference of a transmitting communication member.

In WO2005/069685 an audible intelligibility system combines a public address system with a plurality of spaced apart sensors to evaluate intelligibility of audio output from speakers of the public address system. Processing can take place at some or all of the sensors as well as at a common control element. Evaluations can be based on the use of a pre-determined speech transmission index.

In EP1802175 a broadcasting system for a vessel is disclosed. The system contains two inboard broadcasting amplifiers for a plurality of loudspeakers. The two amplifiers are connected to two ends of an inboard broadcasting line which operates a loudspeaker by a head-to-tail state, and the line is self-controlled by modules for a reconstruction in an obstacle of the line and a transmission of a signal.

In WO2008/036992 a solution for monitoring loudspeaker systems is disclosed. At least one alternating current signal is fed to a loudspeaker line. The voltage and current are measured and the input impedance on the line determined therefrom is compared with a reference value. In order to determine an impedance to be compared with a reference value (Z_{Ref}) in a measurement process, analogue measured voltage and current values are converted into digital signals which are subjected to Fourier transformation. A corresponding set of impedance values is determined from the Fourier-transformed current and voltage values. A mean impedance value is then compared with a reference impedance value.

Hence, there is a need for a simple solution for testing the loudspeakers of a public address system so that one can obtain certainty about messages being broadcasted in a reliable way.

### Summary of the invention

It is an object of embodiments of the present invention to provide for a public address system that allows simple testing of its loudspeaker branches. It is a further object of the invention to provide for a method for acoustical testing of the public address system.

The above objective is accomplished by the solution according to the present invention.

In a first aspect the invention relates to a public address system comprising a first and a second amplifier module, each comprising an amplification means and arranged for receiving a same 10 given signal to be applied to the amplification means and for outputting an amplified signal, said first and second amplifier module being interconnected via a first and second branch, at least the first or the second branch comprising at least one loudspeaker, said first branch being arranged for feeding the amplified signal of the first amplifier module to the second amplifier module and the second branch being arranged for feeding the amplified signal of the second amplifier module to the first amplifier module, said first and second amplifier module further each comprising analysing means for performing comparisons on pairs of signals selected from the received given signal, said amplified signal output by the amplification means comprised in the amplifier module and the amplified signal of the other amplifier module and fed via the first or said second branch, and for yielding, based on the comparisons, an indication of the public address system's operational status.

The proposed solution indeed allows for testing the loudspeaker branches without undue burden. A same signal is applied to both amplifier modules. The two amplifier modules are connected with two branches, at least one of which contains one or more loudspeakers. In each module an amplifier amplifies the applied signal and outputs the amplified signal. The first branch receives the first amplified signal and the second the other amplified signal. The signals are conveyed to the opposite side of the branch, where they are received by the other amplifier module. Using the applied signal, the amplified signal and the amplified signal received via the branch from the other amplifier module some comparisons are performed in an analysis unit that allow determining whether an announcement is broadcasted correctly by the PA system.

In a preferred embodiment a first switch is provided in each amplifier module, arranged for disconnecting the amplifier from the loudspeaker branch. The first switch in each amplifier module is in an advantageous embodiment implemented as a high impedance state of the amplification means. Providing this first switch is especially advantageous in that it offers various options for diagnosis purposes.

Preferably a second switch is provided in each amplifier module so arranged that the amplified signal of that amplifier module can be put on the branch of a failing amplifier in the other amplifier module (wherein the first switch was opened for disconnecting the amplifier). In case one of the amplifiers is failing, this yields the advantage that the other amplifier takes over the other loudspeaker branch. Hence, one has a resilient public address system in case of single failures.

In one embodiment the public address system comprises communication means for exchanging measurement results between the amplifier modules.

In a preferred embodiment the analysing means is arranged for comparing in each amplifier module the received given signal with the amplified signal, for comparing the received given signal with the amplified signal of the other amplifier module and for comparing the amplified signal with the amplified signal of the other amplifier module.

Advantageously, the system is also arranged for performing current measurements.

In one embodiment the PA system is adapted for comparing an ambient noise measurement performed on the first and the second branch.

In another embodiment the public address system is equipped for generating a test signal for acoustical verification of the at least one loudspeaker and/or the amplifiers. Preferably the acoustical verification is carried out in real time.

In another aspect the invention relates to a method for verifying operation of amplification means and loudspeakers of a public address system, comprising a first and a second amplifier module, each comprising an amplification means, said first and second amplifier module being interconnected via a first and second branch, at least the first or the second branch comprising at least one loudspeaker. The method comprises the steps of :
- applying a same signal to the first and second amplifier module,
- feeding the signals amplified by the amplification means of the amplifier modules via the first and second branch, respectively, to the other amplifier module,
- comparing in each amplifier module pairs of signals selected from the applied signal, said amplified signal output by the amplification means comprised in the amplifier module and the amplified signal of the other amplifier module and fed via said first or said second branch,
- obtaining, based on the comparisons, an indication of the public address system's operational status.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, wherein like reference numerals refer to like elements in the various figures.
Fig.1 illustrates an embodiment of the system according to the invention.
Fig.2 illustrates an embodiment that allows for further failure analysis.
Fig.3 illustrates an example of a system set-up for acoustical verification.

### Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

The present invention proposes a public address (PA) system with which it can easily be tested whether an announcement is still being broadcasted in a correct fashion.

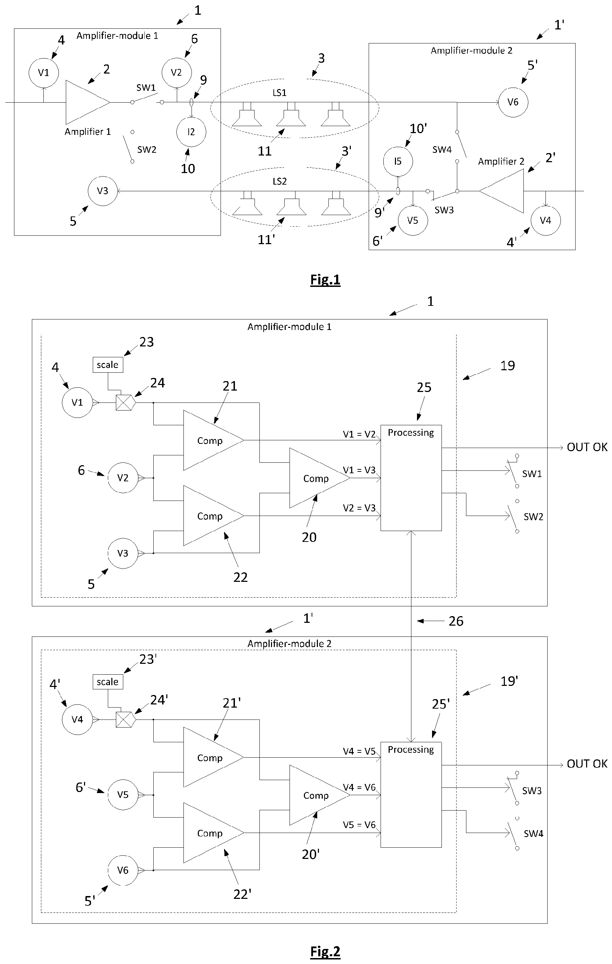

The proposed system comprises in one embodiment two or more separate loudspeaker branches and two or more separate amplifier modules used to drive the loudspeaker branches for availability. Fig.1 represents an illustration of this embodiment. The first amplifier module (indicated in the figure as *amplifier module 1*) takes in the end of the second loudspeaker branch (LS2) and the second amplifier module (*amplifier module 2*) takes in the end of the first loudspeaker branch (LS1). Correct broadcast of the announcement is easily checked by comparison.

Measuring means are provided within each amplifier module. As a minimum, a measuring means is needed at the low level input signal (V1 & V4) and at the loudspeaker branch end signal in the other amplifier module (V3 & V6). The loudspeaker branch end signal (V3) is checked against the incoming low level signal (V1) to be amplified. This test gives an indication whether the other amplifier (*amplifier 2*) is still working correctly or whether no open or short occurs on the other loudspeaker branch (LS2). As illustrated in Fig.2 the measuring means and the comparators are part of what generally can be referred to as an analysing unit 19, wherein the measurements are performed and the measurement results are processed.

In a further embodiment a measuring means is provided on the loudspeaker branch (V2 & V5). By adding a comparison between the incoming low level signal (V1) and the amplified signal (V2) it can be detected if the own amplifier (*amplifier 1*) is still working correctly or no short occurs on the own loudspeaker branch (LS1). The signal V1 can also be a separate signal representative of the low level audio signal that needs to be amplified.

The block diagram in Fig.2 illustrates an embodiment of the analysing unit (19, 19') that allows for further failure analysis of the PA system. Within each amplifier module measurement values obtained from the various measuring means are compared to each other. V1 is compared to V3 by a comparator 20, which indicates if V1 is equal to V3. V1 is compared to V2 (21) which represents if V1 equals V2 and V2 is compared to V3 (22) to check if V2 and V3 are equal. By multiplication with a scaling factor 23 in multiplication means 24 a scaling can be applied to the measurement V1. This scaling factor is determined when designing the system and is equal to the amplification factor of the amplifier. So the comparisons are V1=f(V2, scaling factor), V1=f(V3, scaling factor) and V2=V3.

The comparison results are fed to a processing unit 25. The processing unit is able to communicate comparison results (or a summary thereof) to other amplifier module(s) via a communication link 26. The communication can be done via discrete lines, one for each result, or by means of a more extensive communication method like RS485 or Ethernet.

A decision can be taken based on the measurement results obtained within an amplifier module and on measurement results communicated by the other module(s). In case of failure detection the signal OUT OK is deactivated to indicate to the PA system there is a fault in the amplifier module. The table below lists several fault analysis cases that may occur. In the left column the possible failures are listed. The next columns indicate the result of the different comparisons performed by the amplifier modules. A '1' indicates that the signals are equal and a '0' indicates that the signals differ from each other.

| Failure | V1 = V2 | V1 = V3 | V2 = V3 | | V4 = V5 | V4 = V6 | V5 = V6 | Combination |
|---|---|---|---|---|---|---|---|---|
| ampli 1 failing | 0 | 1 | 0 | | 1 | 0 | 0 | A |
| V1 failing | 0 | 0 | 1 | | 1 | 1 | 1 | B |
| V2 failing | 0 | 1 | 0 | | 1 | 1 | 1 | C |
| V3 failing | 1 | 0 | 0 | | 1 | 1 | 1 | D |
| LS1 open | 1 | 1 | 1 | | 1 | 0 | 0 | E |
| LS1 short | 0 | 1 | 0 | | 1 | 0 | 0 | A |
| LS1 drift (LS lower imp) | 1 | 1 | 1 | | 1 | 1 | 1 | F |
| LS1 drift (LS higher imp) | 1 | 1 | 1 | | 1 | 1 | 1 | F |
| ampli 2 failing | 1 | 0 | 0 | | 0 | 1 | 0 | G |
| V4 failing | 1 | 1 | 1 | | 0 | 0 | 1 | H |
| V5 failing | 1 | 1 | 1 | | 0 | 1 | 0 | I |
| V6 failing | 1 | 1 | 1 | | 1 | 0 | 0 | E |
| LS2 open | 1 | 0 | 0 | | 1 | 1 | 1 | D |
| LS2 short | 1 | 0 | 0 | | 0 | 1 | 0 | G |
| LS2 drift (LS lower imp) | 1 | 1 | 1 | | 1 | 1 | 1 | F |
| LS2 drift (LS higher imp) | 1 | 1 | 1 | | 1 | 1 | 1 | F |

Some rows have the same combination (see the column "combination" to the different letters) of comparison results, but by using the switches further analysis is possible in order to specify the failure.

In a preferred embodiment a first switch (SW1, SW3) is provided in each amplifier module to disconnect the amplifier from the loudspeaker branch. This switch enables the amplifier modules to deduct, when a failure is detected, whether the cause of failure is the amplifier or the loudspeaker-branch. When a failure occurs in the amplifier (amplifier 1 failing), a switch SW1 is opened to separate the loudspeaker branch LS1 from the amplifier (Amplifier 1). Measured signals change accordingly and hence also the comparison results will change_at that moment in line with the diagnosed failure mode. This leads to a further deduction of which part of the amplifier system is failing. The table below lists several first actions and reactions by different failure modes.

| Failure | action | reaction |
|---|---|---|
| ampli 1 failing | SW1 opened | V2<>0 (amb. Noise) |
| V1 failing | no action required | |
| V2 failing | no action required | |
| V3 failing | SW3 opened | V3=?; V5<>0 (amb. noise) |
| LS1 open | SW1 opened | V2=?; V6=? |
| LS1 short | SW1 opened | v2=0; V6=0 |
| LS1 drift (LS lower imp) | no detection, but rare occurrence | |
| LS1 drift (LS higher imp) | no detection, but rare occurrence | |
| ampli 2 failing | SW3 opened | V5<>0 (amb. Noise) |
| V4 failing | no action required | |
| V5 failing | no action required | |
| V6 failing | SW1 opened | V2<>0 (amb. noise); V6=? |
| LS2 open | SW3 opened | V5=?; V3=? |
| LS2 short | SW3 opened | V3=0; V5=0 |
| LS2 drift (LS lower imp) | no detection, but rare occurrence | |
| LS2 drift (LS higher imp) | no detection, but rare occurrence | |

A second switch (SW4) can be closed to connect loudspeaker branch LS1 to Amplifier 2. In this way the system performance doesn't decrease for the receiver of the announcement when an amplifier fails. In case of failure of amplifier 2 the switch SW3 will be opened to deduct that it is amplifier 2 that is failing and that the failure is not caused by LS2. Next the second switch (SW2) can be closed to connect loudspeaker branch LS2 to amplifier 1. Full performance of the PA-system toward the audience remains guaranteed in this way. The table below shows a complete mitigation scheme for different type of failures.

| Failure | action | reaction | action | reaction | OK? |
|---|---|---|---|---|---|
| ampli 1 failing | SW1 opened | V2<>0 (amb. Noise) | SW4 closed | V1=V2;V2=V3; V4=V6; V5=V6 | Y |
| V1 failing | no action required | | | | |
| V2 failing | no action required | | | | |
| V3 failing | SW3 opened | V3=?; V5<>0 (amb. noise) | SW2 closed | V3=?; V5=V6 (return to original state) | Y |
| LS1 open | SW1 opened | V2=?; V6=? | SW4 closed | V4=V6; V5=V6; V2=? | Y |
| LS1 short | SW1 opened | v2=0; V6=0 | | | best effort |
| LS1 drift (LS lower imp) | no detection, but rare occurrence | | | | |
| LS1 drift (LS higher imp) | no detection, but rare occurrence | | | | |
| ampli 2 failing | SW3 opened | V5<>0 (amb. Noise) | SW2 closed | V4=V5;V5=V6; V1=V3; V2=V3 | Y |
| V4 failing | no action required | | | | |
| V5 failing | no action required | | | | |
| V6 failing | SW1 opened | V2<>0 (amb. noise); V6=? | SW4 closed | V6=?; V2=V3 (return to original state) | Y |
| LS2 open | SW3 opened | V5=?; V3=? | SW2 closed | V1=V3; V2=V3; V5=? (connect ampli at the side with the highest level, most loudspeakers) | Y |
| LS2 short | SW. opened | V3=0; V5=0 | | | best effort |
| LS2 drift (LS lower imp) | no detection, but rare occurrence | | | | |
| LS2 drift (LS higher imp) | no detection, but rare occurrence | | | | |

The above described measurements and analyses can be carried out without any need for an extra (intrusive) test signal. The measurements depend on comparisons of pairs of signals. A scaling may be applicable between the compared signals. The scaling factor is typically defined by the amplification factor.

The switch SW1, just as SW3, can be a high impedance state of the amplifier.

The failure mode drift of a loudspeaker branch cannot be measured as can also be seen in the fault analyses table. Via a current transducing means (9,9') and measuring means I2 and I5 (10,10') can the current be measured to check the impedance of the loudspeaker branch. This will cover the detection of the failure mode LS drift.

Advantageously, the proposed structure also lends itself to perform measurements of the ambient noise present in both loudspeaker branches. A comparison can be made between the ambient noise at LS1 branch and LS2 branch. A more reliable noise measurement can be obtained by this method.

A well intelligible announcement is obtained when the announcement is broadcasted at 70dB_{SPL} when ambient noise is below 60dB_{SPL} or 10dB above ambient noise if ambient noise is above 60dB_{SPL}. Ambient noise levels above 60dB_{SPL} often occur in a train or industrial environment. To perform an intelligible announcement the ambient noise needs to be known. A noise measurement can be performed via the loudspeakers. The loudspeaker line becomes floating by opening the first switches (SW1, SW3) and so acoustical noise surrounding the loudspeakers is transduced to an electrical signal on the loudspeaker branch.

There are two loudspeaker branches which arrive at each amplifier module, so the noise measurement can be carried out in a redundant way in each amplifier module. The measurement error can be reduced by using the value from the two branches. In amplifier module 1 a noise measurement is done with measurement means V2 and V3, whereas in amplifier module 2 measurement means V5 and V6 is used. Advantageously the noise measurement can also be used to further diagnose the amplifier modules. This can also be seen from the tables above. Therefore the location of the measurement means V2 and V5 is important : it should be located between the first switch (SW1, SW3) and the loudspeaker branch leaving the amplifier module and not between the amplifier 2 and the first switch.

The proposed structure lends itself also for acoustical verification of the system. A simple test signal can be used for acoustical measurement to avoid complex analyzing methods. The loudspeakers are used for measuring the broadcasted acoustical signal. This is an intrusive test, which may decrease the comfort of listeners present during testing. However, when combined with the continuous test method described earlier, the acoustical testing can be limited to periods of time while no people present in the room (before people are granted entrance of the room). This leaves only a small part of the system undetectable for failures during a certain time interval.

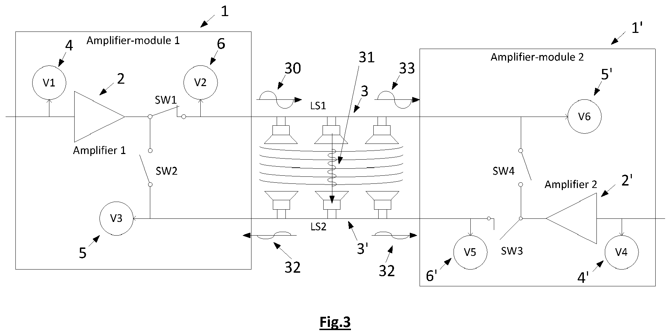

For acoustical testing of the system, which is illustrated in Fig.3, a test signal is transmitted by amplifier module 1 on one loudspeaker branch 30 (LS1). This signal is acoustically broadcasted (31) by the loudspeakers of loudspeaker branch LS1. At the same time the other loudspeaker branch is not driven (switch SW3 opened). The loudspeakers on the loudspeaker branch (LS2) act as an electrodynamic microphone (same as for the noise measurement), converting the acoustical signal 31 into an electrical signal 32, which is present on the loudspeaker line because of the high line impedance because the amplifier is not connected to the loudspeaker line. This signal arrives at the measurement circuit V3, where it can be compared with signal V2. The ratio between V3 and V2 is defined at system installation and stored within the processing unit. The obtained ratio between the transmitted signal V2 and the received signal V3 is checked against the stored ratio each time an acoustical test is performed. When the measured ratio matches the stored value, the acoustical path is still operating as expected. The same measurement can be carried out redundantly at the side of amplifier module 2 with measurement circuits V6 and V5. The broadcasted electrical signal by amplifier module 1 (33) is measured on measuring means V6 and the converted acoustical signal to electrical signal 32 is measured with measuring means V5.

The other amplifier and loudspeaker branch can be measured also by sending from amplifier2 over LS2 and picking up the acoustical signal with LS1.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. Public address system comprising a first (1) and a second (1') amplifier module, each comprising an amplification means (2,2') and arranged for receiving a same given signal to be applied to said amplification means and for outputting an amplified signal, said first and second amplifier module being interconnected via a first (LS1) and second (LS2) branch, at least said first or said second branch comprising at least one loudspeaker (11,11'), said first branch being arranged for feeding said amplified signal of said first amplifier module to said second amplifier module and said second branch being arranged for feeding said amplified signal of said second amplifier module to said first amplifier module, said first and second amplifier module further each comprising analysing means (19,19') comprising measurement means (4,4',5,5',6,6') for performing comparisons on pairs of signals selected from said received given signal, said amplified signal output by said amplification means comprised in the amplifier module and said amplified signal of the other amplifier module and fed via said first or said second branch, and for yielding, based on said comparisons, an indication of the public address system's operational status.

2. Public address system as in claim 1, wherein in each amplifier module a first switch (SW1,SW3) is provided, arranged for preventing the amplified signal from passing towards the other amplifier module.

3. Public address system as in claim 2, wherein said first switch in each amplifier module is implemented as a high impedance state of said amplification means.

4. Public address system as in claim 2 or 3, wherein in each amplifier module a second switch (SW2,SW4) is provided between an output of said amplification means of the own amplifier module and an input arranged for receiving the amplified signal of the other amplifier module.

5. Public address system as in any of the previous claims, further comprising communication means for communicating measurement results between said first and said second amplifier module, said measurements results provided by said analysing means.

6. Public address system as in any of the previous claims, wherein said analysing means is arranged for comparing in each amplifier module said received given signal with said amplified signal, for comparing said received given signal with said amplified signal of the other amplifier module and for comparing said amplified signal with said amplified signal of the other amplifier module.

7. Public address system as in any of the previous claims, further arranged for performing current measurements.

8. Public address system as in any of claims 2 to 4, wherein said first and said second branch each comprise at least one loudspeaker (11,11') whereby each analysing means (19,19') is configured to perform an ambient noise measurement using measurement means (5,5',6,6') for said amplified signal output by said amplification means and for said amplified signal of the other amplifier module, wherein the measurement means (6,6') for said amplified signal output by said amplification means are positioned between said first switch (SW1, SW3) and said at least one loudspeaker of said first and second branch, so that the public address system is arranged for comparing an ambient noise measurement performed on said first and said second branch,

9. Public address system as in any of the previous claims, arranged for generating a test signal for acoustical verification of said at least one loudspeaker and/or said amplification means.

10. Public address system as in claim 9, arranged for performing said acoustical verification in real time.

11. Method for verifying operation of amplification means and loudspeakers of a public address system, comprising a first and a second amplifier module, each comprising an amplification means (2,2'), said first and second amplifier module being interconnected via a first (LS1) and second (LS2) branch, at least said first or said second branch comprising at least one loudspeaker (11,11'), the method comprising the steps of :
- applying a same signal to said first and second amplifier module,
- feeding the signals amplified by said amplification means of said amplifier modules via said first and second branch, respectively, to the other amplifier module,
- measuring and comparing in each amplifier module pairs of signals selected from said applied signal, said amplified signal output by said amplification means comprised in the amplifier module and said amplified signal of the other amplifier module and fed via said first or said second branch,
- obtaining, based on said comparisons, an indication of the public address system's operational status.

## Patentansprüche

1. Beschallungsanlage, umfassend ein erstes (1) und ein zweites (1') Verstärkermodul, wovon jedes ein Verstärkungsmittel (2, 2') umfasst und angeordnet ist, um ein gleiches bestimmtes Signal zu empfangen, das auf das Verstärkungsmittel anzuwenden ist, und um ein verstärktes Signal auszugeben, wobei das erste und zweite Verstärkermodul über eine erste (LS1) und zweite (LS2) Verzweigung miteinander verbunden sind, wobei mindestens die erste oder die zweite Verzweigung mindestens einen Lautsprecher (11, 11') umfassen, wobei die erste Verzweigung angeordnet ist, um das verstärkte Signal des ersten Verstärkermoduls dem zweiten Verstärkermodul zuzuführen, und wobei die zweite Verzweigung angeordnet ist, um das verstärkte Signal des zweiten Verstärkermoduls dem ersten Verstärkermodul zuzuführen, wobei das erste und zweite Verstärkermodul ferner jeweils Analysemittel (19, 19') umfassen, die Messmittel (4, 4', 5, 5', 6, 6') umfassen, um Vergleiche an Signalpaaren durchzuführen, die aus dem empfangenen bestimmten Signal, dem verstärkten Signal, das von dem Verstärkungsmittel ausgegeben wird, das in dem Verstärkermodul enthalten ist, und dem verstärkten Signal des anderen Verstärkermoduls, das über die erste oder die zweite Verzweigung zugeführt wird, ausgewählt werden, und um basierend auf den Vergleichen eine Angabe über den Betriebsstatus der Beschallungsanlage zu liefern.

2. Beschallungsanlage nach Anspruch 1, wobei in jedem Verstärkermodul ein erster Schalter (SW1, SW3) bereitgestellt und angeordnet ist, um das verstärkte Signal daran zu hindern, zu dem anderen Verstärkermodul zu gelangen.

3. Beschallungsanlage nach Anspruch 2, wobei der erste Schalter in jedem Verstärkermodul als Hochimpedanzzustand des Verstärkungsmittels implementiert ist.

4. Beschallungsanlage nach Anspruch 2 oder 3, wobei in jedem Verstärkermodul ein zweiter Schalter (SW2, SW4) zwischen einem Ausgang des Verstärkungsmittels des eigenen Verstärkermoduls und einem Eingang bereitgestellt ist, der angeordnet ist, um das verstärkte Signal des anderen Verstärkermoduls zu empfangen.

5. Beschallungsanlage nach einem der vorhergehenden Ansprüche, ferner umfassend Kommunikationsmittel zum Mitteilen von Messergebnissen zwischen dem ersten und dem zweiten Verstärkermodul, wobei die Messergebnisse von den Analysemitteln bereitgestellt werden.

6. Beschallungsanlage nach einem der vorhergehenden Ansprüche, wobei die Analysemittel angeordnet sind, um in jedem Verstärkermodul das empfangene bestimmte Signal mit dem verstärkten Signal zu vergleichen, um das empfangene bestimmte Signal mit dem verstärkten Signal des anderen Verstärkermoduls zu vergleichen, und um das verstärkte Signal mit dem verstärkten Signal des anderen Verstärkermoduls zu vergleichen.

7. Beschallungsanlage nach einem der vorhergehenden Ansprüche, ferner angeordnet, um laufende Messungen durchzuführen.

8. Beschallungsanlage nach einem der Ansprüche 2 bis 4, wobei
die erste und die zweite Verzweigung jeweils mindestens einen Lautsprecher (11, 11') umfassen, wobei jedes Analysemittel (19, 19') ausgelegt ist, um eine Umgebungsgeräuschmessung unter Verwendung von Messmitteln (5, 5', 6, 6') für das verstärkte Signal, das von dem Verstärkungsmittel ausgegeben wird, und für das verstärkte Signal des anderen Verstärkermoduls durchzuführen, wobei die Messmittel (6, 6') für das verstärkte Signal, das von dem Verstärkungsmittel ausgegeben wird,
zwischen dem ersten
Schalter (SW1, SW3) und dem mindestens einen Lautsprecher der ersten und zweiten Verzweigung angeordnet sind, so dass die Beschallungsanlage angeordnet ist, um eine Umgebungsgeräuschmessung zu vergleichen, die an der ersten und der zweiten Verzweigung durchgeführt wird.

9. Beschallungsanlage nach einem der vorhergehenden Ansprüche, angeordnet, um ein Testsignal zur akustischen Überprüfung des mindestens einen Lautsprechers und/oder des Verstärkungsmittels zu erzeugen.

10. Beschallungsanlage nach Anspruch 9, angeordnet, um die akustische Überprüfung in Echtzeit durchzuführen.

11. Verfahren zum Überprüfen des Betriebs von Verstärkungsmitteln und Lautsprechern einer Beschallungsanlage, umfassend ein erstes und ein zweites Verstärkermodul, wovon jedes ein Verstärkungsmittel (2, 2') umfasst, wobei das erste und zweite Verstärkermodul über eine erste (LS1) und zweite (LS2) Verzweigung miteinander verbunden sind, wobei mindestens die erste oder die zweite Verzweigung mindestens einen Lautsprecher (11, 11') umfassen, wobei das Verfahren folgende Schritte umfasst:
- Anwenden eines gleichen Signals auf das erste und zweite Verstärkermodul,
- Zuführen der Signale, die von den Verstärkungsmitteln der Verstärkermodule verstärkt werden, über die erste und zweite Verzweigung jeweils zu dem anderen Verstärkermodul,
- Messen und Vergleichen,
in jedem Verstärkermodul, von Signalpaaren, die aus dem angewendeten Signal, dem verstärkten Signal, das von dem Verstärkungsmittel ausgegeben wird, das in dem Verstärkermodul enthalten ist, und dem verstärkten Signal des anderen Verstärkermoduls, das über die erste oder die zweite Verzweigung zugeführt wird, ausgewählt werden,
- Erhalten, basierend auf den Vergleichen, einer Angabe über den Betriebsstatus der Beschallungsanlage.

## Revendications

1. Système de sonorisation comprenant un premier module amplificateur (1) et un deuxième module amplificateur (1'), chacun d'eux comprenant un moyen d'amplification (2, 2') et étant agencé pour recevoir un même signal donné à appliquer aux dits moyens d'amplification et pour délivrer un signal amplifié, lesdits premier et deuxième modules amplificateurs étant interconnectés par l'intermédiaire d'une première branche (LS1) et d'une deuxième branche (LS2), au moins ladite première branche ou ladite deuxième branche comprenant au moins un haut-parleur (11, 11'), ladite première branche étant agencée pour alimenter ledit signal amplifié dudit premier module amplificateur dans ledit deuxième module amplificateur et ladite deuxième branche étant agencée pour alimenter ledit signal amplifié dudit deuxième module amplificateur dans ledit premier module amplificateur, chacun desdits premier et deuxième modules amplificateurs comprenant en outre un moyen d'analyse (19, 19') comprenant un moyen de mesure (4, 4', 5, 5', 6, 6') pour effectuer des comparaisons sur des paires de signaux sélectionnés parmi ledit signal donné reçu, ledit signal amplifié délivré par lesdits moyens d'amplification compris dans le module amplificateur et ledit signal amplifié de l'autre module amplificateur et alimentés par l'intermédiaire de ladite première branche ou de ladite deuxième branche, et pour donner, sur la base desdites comparaisons, une indication de l'état de fonctionnement du système de sonorisation.

2. Système de sonorisation selon la revendication 1, dans lequel, dans chaque module amplificateur, il est prévu un premier commutateur (SW1, SW3) agencé pour empêcher le passage du signal amplifié à l'autre module amplificateur.

3. Système de sonorisation selon la revendication 2, dans lequel ledit premier commutateur dans chaque module amplificateur est mis en oeuvre en tant qu'un état de haute impédance dudit moyen d'amplification.

4. Système de sonorisation selon la revendication 2 ou 3, dans lequel, dans chaque module amplificateur, il est prévu un deuxième commutateur (SW2, SW4) entre une sortie dudit moyen d'amplification du propre module amplificateur et une entrée agencée pour recevoir le signal amplifié de l'autre module amplificateur.

5. Système de sonorisation selon l'une quelconque des revendications précédentes, comprenant en outre un moyen de communication pour communiquer des résultats de mesure entre ledit premier module amplificateur et ledit deuxième module amplificateur, lesdits résultats de mesure étant fournis par lesdits moyens d'analyse.

6. Système de sonorisation selon l'une quelconque des revendications précédentes, dans lequel lesdits moyens d'analyse sont agencés pour comparer, dans chaque module amplificateur, ledit signal donné reçu au dit signal amplifié, comparer ledit signal donné reçu au dit signal amplifié de l'autre module amplificateur et comparer ledit signal amplifié au dit signal amplifié de l'autre module amplificateur.

7. Système de sonorisation selon l'une quelconque des revendications précédentes, agencé en outre pour effectuer des mesures de courant.

8. Système de sonorisation selon l'une quelconque des revendications 2 à 4, dans lequel
chacune de ladite première branche et de ladite deuxième branche comprend au moins un haut-parleur (11, 11') de telle manière que chaque moyen d'analyse (19, 19') soit configuré pour effectuer une mesure de bruit ambiant en utilisant un moyen de mesure (5, 5', 6, 6') pour ledit signal amplifié délivré par ledit moyen d'amplification et pour ledit signal amplifié de l'autre module amplificateur, dans lequel le moyen de mesure (6, 6') pour ledit signal amplifié délivré par ledit moyen d'amplification est positionné entre ledit premier commutateur (SW1, SW3) et ledit au moins un haut-parleur desdites première et deuxième branches, de sorte que le système de sonorisation soit agencé pour comparer une mesure de bruit ambiant effectuée sur lesdites premières et deuxième branches.

9. Système de sonorisation selon l'une quelconque des revendications précédentes, agencé pour générer un signal de test pour une vérification acoustique dudit au moins un haut-parleur et/ou desdits moyens d'amplification.

10. Système de sonorisation selon la revendication 9, agencé pour effectuer ladite vérification acoustique en temps réel.

11. Procédé de vérification d'un fonctionnement de moyens d'amplification et de haut-parleurs d'un système de sonorisation comprenant un premier module amplificateur et un deuxième module amplificateur, chacun d'eux comprenant un moyen d'amplification (2, 2'), lesdits premier et deuxième modules amplificateurs étant interconnectés par l'intermédiaire d'une première branche (LS1) et d'une deuxième branche (LS2), au moins ladite première branche ou ladite deuxième branche comprenant au moins un haut-parleur (11, 11'), le procédé comprenant les étapes de :
- l'application d'un même signal aux dits premier et deuxième modules amplificateurs,
- l'alimentation des signaux amplifiés par lesdits moyens d'amplification desdits modules amplificateurs, par l'intermédiaires respectivement desdites première et deuxième branches, dans l'autre module amplificateur,
- la mesure et la comparaison, dans chaque paire de modules amplificateurs, de signaux sélectionnés parmi ledit signal appliqué, ledit signal amplifié délivré par ledit moyen d'amplification compris dans le module amplificateur et ledit signal amplifié de l'autre module amplificateur et alimentés par l'intermédiaire de ladite première branche ou de ladite deuxième branche,
- l'obtention, sur la base desdites comparaisons, d'une indication de l'état de fonctionnement du système de sonorisation.
